# EUROPEAN PATENT APPLICATION

(11) **EP 4 650 831 A1**
(43) Date of publication of application: **19.11.2025**
(21) Application number: 23926361.9
(22) Date of filing: 20.03.2023
(51) Int. Cl.: G01T 1/24

(54) **RADIATION DETECTION DEVICE, METHOD FOR MANUFACTURING SAME, AND RADIATION CT DEVICE**

(30) Priority: 07.03.2023 JP 2023034932
(71) Applicant: Canon Kabushiki Kaisha, Tokyo, 146-8501 (JP)
(72) Inventor: YOSHIOKA, Takeshi, Tokyo 146-8501 (JP); SAITO, Tatsuya, Tokyo 146-8501 (JP); ITO, Kentaro, Tokyo 146-8501 (JP)
(74) Representative: WESER & Kollegen Patentanwälte PartmbB
(86) International application number: PCT/JP2023/010822
(87) International publication number: WO 2024/185152

(57) **Abstract**

A radiation detection apparatus comprises a board, a first electrode located on the board, a semiconductor layer located on the first electrode, the semiconductor layer producing a charge corresponding to radiation incident on the radiation detection apparatus, a second electrode located on the semiconductor layer, the second electrode having a first surface contacting the semiconductor layer and a second surface opposite the first surface; and an insulating layer contacting the second surface of the second electrode.

## Description

### TECHNICAL FIELD

The present invention relates to a radiation detection apparatus, a manufacturing method thereof, and a radiation CT apparatus.

### BACKGROUND ART

A type of radiation detection apparatus that converts radiation into light using a scintillator and then converts that light into a charge by a semiconductor layer, as well as a type of radiation detection apparatus that converts radiation into a charge by a semiconductor layer, are known. In the type that converts radiation into a charge by a semiconductor layer, electrodes are disposed such that the semiconductor layer is interposed therebetween, and a sensor part is constituted by the semiconductor layer and the electrodes. Patent Literature (PTL) 1 proposes, in the type of radiation detection apparatus that converts radiation directly into a charge by a semiconductor layer, improving the moisture resistance of the semiconductor layer by covering side surfaces of the semiconductor layer with an organic layer.

### CITATION LIST

### PATENT LITERATURE

PTL 1: U.S. Patent No. 7223982

### SUMMARY OF INVENTION

### TECHNICAL PROBLEM

In PTL 1, side surfaces of the semiconductor layer are protected from outside air. However, there is a risk that the electrodes constituting the detection unit will deteriorate due to oxidation or the like if those electrodes are exposed to outside air.

### SOLUTION TO PROBLEM

An aspect of the present invention provides a technique for appropriately protecting a detection unit of a radiation detection apparatus. According to some embodiments, a radiation detection apparatus comprising: a board; a first electrode located on the board; a semiconductor layer located on the first electrode, the semiconductor layer producing a charge corresponding to radiation incident on the radiation detection apparatus; a second electrode located on the semiconductor layer, the second electrode having a first surface contacting the semiconductor layer and a second surface opposite the first surface; and an insulating layer contacting the second surface of the second electrode is provided.

### ADVANTAGEOUS EFFECTS OF INVENTION

According to some embodiments, a detection unit of a radiation detection apparatus is appropriately protected.

Other features and advantages of the present invention will be apparent from the following description taken in conjunction with the accompanying drawings. Note that the same reference numerals denote the same or like components throughout the accompanying drawings.

### BRIEF DESCRIPTION OF DRAWINGS

The accompanying drawings, which are incorporated in and constitute a part of the specification, illustrate embodiments of the invention and, together with the description, serve to explain principles of the invention.
FIG. 1 is a schematic diagram illustrating an example of the configuration of a radiation detection apparatus according to some embodiments.
FIG. 2 is a schematic diagram illustrating an example of the configuration of a radiation detection apparatus according to some embodiments.
FIG. 3 is a block diagram illustrating an example of the configuration of a radiation CT apparatus according to some embodiments.

### DESCRIPTION OF EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

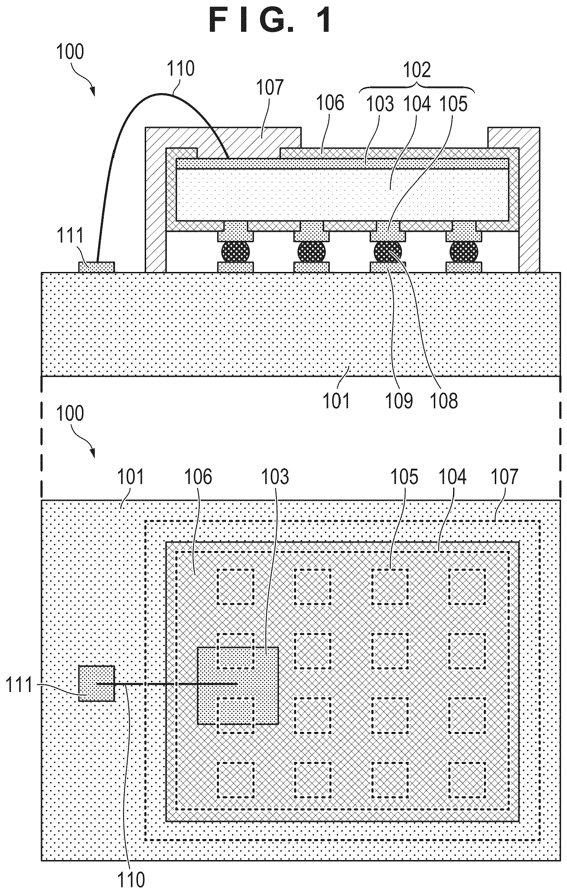

An example of the configuration of a radiation detection apparatus 100 according to some embodiments will be described with reference to FIG. 1. The radiation detection apparatus 100 has a function for detecting incident radiation. When the radiation detection apparatus 100 is used to generate a radiograph, the radiation detection apparatus 100 may be referred to as a radiographic imaging apparatus. The upper part of FIG. 1 is a cross-sectional side view of the radiation detection apparatus 100. The lower part of FIG. 1 is a plan view of the radiation detection apparatus 100. In the plan view, the outlines of constituent elements hidden by other constituent elements are indicated by broken lines. In addition, in the plan view, a sealing member 107 is omitted in order to make the arrangement of an insulating layer 106 easier to understand, and the outlines of the sealing member 107 are also indicated by broken lines.

The radiation detection apparatus 100 includes a board 101 and a detection unit 102 located on the board 101. Of the board 101, a surface on which the detection unit 102 is disposed will be called an upper surface (the surface on the upper side in the cross-sectional side view). Of the board 101, the surface opposite the upper surface will be called a lower surface (the surface on the lower side in the cross-sectional side view). Of the board 101, the surfaces connecting the upper surface and the lower surface will be called side surfaces (the left side and the right side surfaces in the cross-sectional side view). When the board 101 has a cuboid shape, the board 101 has four side surfaces. The board 101 may be a printed circuit board (also called a PCB), for example.

The detection unit 102 includes an upper electrode 103, a semiconductor layer 104, and lower electrodes 105. The semiconductor layer 104 is interposed between the upper electrode 103 and the lower electrodes 105. In the cross-sectional side view, the lower electrodes 105 are located on the board 101, the semiconductor layer 104 is located on the lower electrodes 105, and the upper electrode 103 is located on the semiconductor layer 104.

The radiation detection apparatus 100 has an individual lower electrode 105 for each of pixels. In the example illustrated in FIG. 1, the radiation detection apparatus 100 has pixels disposed in four rows by four columns. Accordingly, the radiation detection apparatus 100 has a total of 16 lower electrodes 105 disposed in four rows by four columns. The number of pixels of the radiation detection apparatus 100 is not limited to this example, and the radiation detection apparatus 100 typically has more pixels. The upper electrode 103 is disposed in common across a plurality of the pixels. In the example in FIG. 1, the radiation detection apparatus 100 has one common upper electrode 103 for the 16 pixels. Instead, however, the radiation detection apparatus 100 may have an individual upper electrode 103 for each of the pixels (i.e., a total of 16).

Of the semiconductor layer 104, a surface on which the upper electrode 103 is disposed will be called an upper surface (the surface on the upper side in the cross-sectional side view). Of the semiconductor layer 104, the surface opposite the upper surface will be called a lower surface (the surface on the lower side in the cross-sectional side view). Of the semiconductor layer 104, the surfaces connecting the upper surface and the lower surface will be called side surfaces (the left side and the right side surfaces in the cross-sectional side view). When the semiconductor layer 104 has a cuboid shape, the semiconductor layer 104 has four side surfaces facing in different directions from each other.

Of the upper electrode 103, a surface on which the semiconductor layer 104 is disposed will be called a lower surface (the surface on the lower side in the cross-sectional side view). Of the upper electrode 103, the surface opposite the lower surface will be called an upper surface (the surface on the upper side in the cross-sectional side view). Of the upper electrode 103, the surfaces connecting the upper surface and the lower surface will be called side surfaces (the left side and the right side surfaces in the cross-sectional side view). When the upper electrode 103 has a cuboid shape, the upper electrode 103 has four side surfaces facing in different directions from each other.

Of each lower electrode 105, a surface on which the semiconductor layer 104 is disposed will be called an upper surface (the surface on the upper side in the cross-sectional side view). Of each lower electrode 105, the surface opposite the upper surface will be called a lower surface (the surface on the lower side in the cross-sectional side view). Of each lower electrode 105, the surfaces connecting the upper surface and the lower surface will be called side surfaces (the left side and the right side surfaces in the cross-sectional side view). When the lower electrode 105 has a cuboid shape, the lower electrode 105 has four side surfaces facing in different directions from each other. As illustrated in FIG. 1, the side surface of each lower electrode 105 has a step.

The lower surface of the upper electrode 103 contacts the upper surface of the semiconductor layer 104. In the example illustrated in FIG. 1, the upper surface of the semiconductor layer 104 has the same shape as the lower surface of the upper electrode 103. When viewing the upper surface of the board 101 in plan view, an outer edge of the upper surface of the semiconductor layer 104 coincides with an outer edge of the lower surface of the upper electrode 103. Accordingly, the entire lower surface of the upper electrode 103 contacts the entire upper surface of the semiconductor layer 104. Instead, however, the lower surface of the upper electrode 103 may be smaller than the upper surface of the semiconductor layer 104. Furthermore, instead, the upper electrode 103 may extend to the side surfaces of the semiconductor layer 104 and contact at least a part of the side surfaces of the semiconductor layer 104.

The upper surface of each lower electrode 105 contacts the lower surface of the semiconductor layer 104. When viewing the upper surface of the board 101 in plan view, the upper surface of each lower electrode 105 is smaller than the lower surface of the semiconductor layer 104. Accordingly, the entire upper surface of each lower electrode 105 contacts part of the lower surface of the semiconductor layer 104.

The semiconductor layer 104 produces a charge corresponding to radiation incident on the radiation detection apparatus 100. The semiconductor layer 104 may produce a charge corresponding to radiation incident on the semiconductor layer 104. In this case, the semiconductor layer 104 may be constituted by a compound semiconductor such as, for example, cadmium zinc telluride.

The upper electrode 103 and the lower electrodes 105 are constituted by a conductor. The upper electrode 103 and the lower electrodes 105 may be constituted by a metal such as copper, for example.

The detection unit 102 is at least partially covered by the insulating layer 106. A specific arrangement of the insulating layer 106 will be described hereinafter. The insulating layer 106 partially covers the upper surface of the upper electrode 103. The part of the insulating layer 106 that partially covers the upper surface of the upper electrode 103 contacts the upper surface of the upper electrode 103. The part of the upper surface of the upper electrode 103 that is not covered by the insulating layer 106 is used to connect a wire 110.

The insulating layer 106 includes a part that covers the side surfaces of the upper electrode 103. The part of the insulating layer 106 that covers the side surfaces of the upper electrode 103 contacts the side surfaces of the upper electrode 103. In the example illustrated in FIG. 1, the insulating layer 106 covers all four side surfaces of the upper electrode 103. Instead, however, the insulating layer 106 may only cover some of the four side surfaces of the upper electrode 103.

The insulating layer 106 includes a part that covers the side surfaces of the semiconductor layer 104. The part of the insulating layer 106 that covers the side surfaces of the semiconductor layer 104 contacts the side surfaces of the semiconductor layer 104. In the example illustrated in FIG. 1, the insulating layer 106 covers all four side surfaces of the semiconductor layer 104. Instead, however, the insulating layer 106 may only cover some of the four side surfaces of the semiconductor layer 104.

The insulating layer 106 includes a part that covers a part of the lower surface of the semiconductor layer 104. The part of the insulating layer 106 that covers the part of the lower surface of the semiconductor layer 104 contacts the lower surface of the semiconductor layer 104. In the example illustrated in FIG. 1, the insulating layer 106 contacts the entirety of the part of the lower surface of the semiconductor layer 104 not contacting the lower electrodes 105. As described above, the insulating layer 106 extends from the top of the detection unit 102 to the sides of the detection unit 102, and further extends to the bottom of the detection unit 102.

The insulating layer 106 may be constituted by an inorganic material, for example. Specifically, the insulating layer 106 may be constituted by an oxide, a nitride, or an oxynitride. More specifically, the insulating layer 106 may be constituted by silicon nitride, silicon oxide, silicon oxynitride, or aluminum oxide. The insulating layer 106 may be constituted by a single layer, or may be constituted by a layered body including a plurality of layers. When the insulating layer 106 is constituted by layers, each of the plurality of layers may be constituted by the same material, or may be constituted by different materials. The insulating layer 106 may be constituted by an organic material, for example. Furthermore, the insulating layer 106 may be a layered body including an inorganic material and an organic material.

Covering part of the detection unit 102 with the insulating layer 106 makes it possible to separate that part of the detection unit 102 from the exterior (e.g., from air inside a housing of the radiation detection apparatus 100). This makes it possible to suppress degradation of the detection unit 102 caused by external influences. Because the insulating layer 106 protects the detection unit 102 from the exterior in this manner, the insulating layer 106 may be called a protective layer or an insulating protective layer.

Electrodes 109 and an electrode 111 are formed on the upper surface of the board 101. The lower electrodes 105 (specifically, the lower surfaces thereof) are bonded to the board 101 (specifically, to the electrodes 109 thereof) by bumps 108. The bumps 108 are conductive, and thus the electrodes 109 and the lower electrodes 105 are electrically connected to each other. The bumps 108 are formed from solder, for example. The electrodes 109 are electrically connected to other circuits mounted on the board 101, or to other circuits mounted on a board different from the board 101, through interconnects formed on the board 101. When the radiation detection apparatus 100 is in use, a signal corresponding to the charge generated in the semiconductor layer 104 is transmitted to other circuits through these interconnects.

One end of the wire 110 is connected to the electrode 111 of the board 101. The other end of the wire 110 is connected to the upper electrode 103 (specifically, to the upper surface thereof). The electrode 111 and the upper electrode 103 are electrically connected to each other by the wire 110. The electrode 111 is electrically connected to other circuits mounted on the board 101, or to other circuits mounted on a board different from the board 101, through interconnects formed on the board 101. When the radiation detection apparatus 100 is in use, a predetermined potential is supplied to the upper electrode 103 from other circuits.

The sealing member 107 seals the part of the upper surface of the upper electrode 103 that is not covered by the insulating layer 106. Furthermore, the sealing member 107 extends from a part of the semiconductor layer 104 on sides thereof to the upper surface of the board 101, and therefore seals the space between the detection unit 102 and the board 101. In the example in FIG. 1, a space (i.e., a region where no solids are present) is present between the detection unit 102 and the board 101. Instead, however, the space between the detection unit 102 and the board 101 may be filled with the sealing member 107. The sealing member 107 is constituted by an organic material, for example.

In the example in FIG. 1, the insulating layer 106 covers the top, sides, and bottom of the detection unit 102, respectively. Instead, however, the insulating layer 106 may only cover some of the top, sides, and bottom of the detection unit 102, e.g., only the top, only the sides, only the bottom, or parts aside from the top, aside from the sides, and aside from the bottom. In this case, the part covered by the insulating layer 106 is protected from the exterior.

A method for manufacturing the radiation detection apparatus 100 will be described. The upper electrode 103 is formed on one surface of the semiconductor layer 104. Then, the periphery of the semiconductor layer 104 and the upper electrode 103 is covered with the insulating layer 106, and a part of the insulating layer 106 is removed. Then, the lower electrodes 105 are formed in the on the part of the lower surface of the semiconductor layer 104 from which the insulating layer 106 has been removed. The lower electrodes 105 and the electrodes 109 of the board 101 are then bonded by the bumps 108. Then, the part of the upper electrode 103 of the semiconductor layer 104 that is not covered by the insulating layer 106 is connected to the electrode 111 of the board 101 by the wire 110. The detection unit 102 is then sealed with the sealing member 107.

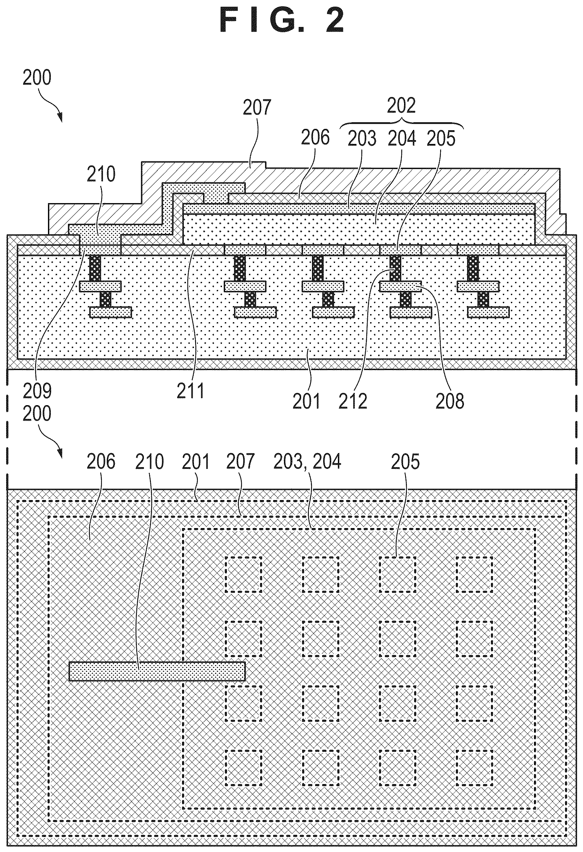

An example of the configuration of a radiation detection apparatus 200 according to some embodiments will be described with reference to FIG. 2. The radiation detection apparatus 200 has a function for detecting incident radiation. When the radiation detection apparatus 200 is used to generate a radiograph, the radiation detection apparatus 200 may be referred to as a radiographic imaging apparatus. The upper part of FIG. 2 is a cross-sectional side view of the radiation detection apparatus 200. The lower part of FIG. 2 is a plan view of the radiation detection apparatus 200. In the plan view, the outlines of constituent elements hidden by other constituent elements are indicated by broken lines. In addition, in the plan view, a sealing member 207 is omitted in order to make the arrangement of an insulating layer 106 easier to understand, and the outlines of the sealing member 207 are also indicated by broken lines.

The radiation detection apparatus 200 includes a board 201 and a detection unit 202 located on the board 201. Of the board 201, a surface on which the detection unit 202 is disposed will be called an upper surface (the surface on the upper side in the cross-sectional side view). Of the board 201, the surface opposite the upper surface will be called a lower surface (the surface on the lower side in the cross-sectional side view). Of the board 201, the surfaces connecting the upper surface and the lower surface will be called side surfaces (the left side and the right side surfaces in the cross-sectional side view). When the board 201 has a cuboid shape, the board 201 has four side surfaces. The board 201 may be a semiconductor substrate, for example.

The detection unit 202 includes an upper electrode 203, a semiconductor layer 204, and lower electrodes 205. The semiconductor layer 204 is interposed between the upper electrode 203 and the lower electrodes 205. In the cross-sectional side view, the lower electrodes 205 are located on the board 201, the semiconductor layer 204 is located on the lower electrodes 205, and the upper electrode 203 is located on the semiconductor layer 204.

The radiation detection apparatus 200 has an individual lower electrode 205 for each of pixels. In the example illustrated in FIG. 2, the radiation detection apparatus 200 has pixels disposed in four rows by four columns. Accordingly, the radiation detection apparatus 200 has a total of 16 lower electrodes 205 disposed in four rows by four columns. The number of pixels of the radiation detection apparatus 200 is not limited to this example, and the radiation detection apparatus 200 typically has more pixels. The upper electrode 203 is disposed in common across a plurality of the pixels. In the example in FIG. 2, the radiation detection apparatus 200 has one common upper electrode 203 for the 16 pixels. Instead, however, the radiation detection apparatus 200 may have an individual upper electrode 203 for each of the pixels (i.e., a total of 16).

Of the semiconductor layer 204, a surface on which the upper electrode 203 is disposed will be called an upper surface (the surface on the upper side in the cross-sectional side view). Of the semiconductor layer 204, the surface opposite the upper surface will be called a lower surface (the surface on the lower side in the cross-sectional side view). Of the semiconductor layer 204, the surfaces connecting the upper surface and the lower surface will be called side surfaces (the left side and the right side surfaces in the cross-sectional side view). When the semiconductor layer 204 has a cuboid shape, the semiconductor layer 204 has four side surfaces facing in different directions from each other.

Of the upper electrode 203, a surface on which the semiconductor layer 204 is disposed will be called a lower surface (the surface on the lower side in the cross-sectional side view). Of the upper electrode 203, the surface opposite the lower surface will be called an upper surface (the surface on the upper side in the cross-sectional side view). Of the upper electrode 203, the surfaces connecting the upper surface and the lower surface will be called side surfaces (the left side and the right side surfaces in the cross-sectional side view). When the upper electrode 203 has a cuboid shape, the upper electrode 203 has four side surfaces facing in different directions from each other.

Of each lower electrode 205, a surface on which the semiconductor layer 204 is disposed will be called an upper surface (the surface on the upper side in the cross-sectional side view). Of each lower electrode 205, the surface opposite the upper surface will be called a lower surface (the surface on the lower side in the cross-sectional side view). Of each lower electrode 205, the surfaces connecting the upper surface and the lower surface will be called side surfaces (the left side and the right side surfaces in the cross-sectional side view). When the lower electrode 205 has a cuboid shape, the lower electrode 205 has four side surfaces facing in different directions from each other.

The lower surface of the upper electrode 203 contacts the upper surface of the semiconductor layer 204. In the example illustrated in FIG. 2, the upper surface of the semiconductor layer 204 has the same shape as the lower surface of the upper electrode 203. When viewing the upper surface of the board 201 in plan view, an outer edge of the upper surface of the semiconductor layer 204 coincides with an outer edge of the lower surface of the upper electrode 203. Accordingly, the entire lower surface of the upper electrode 203 contacts the entire upper surface of the semiconductor layer 204. Instead, however, the lower surface of the upper electrode 203 may be smaller than the upper surface of the semiconductor layer 204. Furthermore, instead, the upper electrode 203 may extend to the side surfaces of the semiconductor layer 204 and contact at least a part of the side surfaces of the semiconductor layer 204.

The upper surface of each lower electrode 205 contacts the lower surface of the semiconductor layer 204. When viewing the upper surface of the board 201 in plan view, the upper surface of each lower electrode 205 is smaller than the lower surface of the semiconductor layer 204. Accordingly, the entire upper surface of each lower electrode 205 contacts part of the lower surface of the semiconductor layer 204.

The semiconductor layer 204 produces a charge corresponding to radiation incident on the radiation detection apparatus 200. The semiconductor layer 204 may produce a charge corresponding to radiation incident on the semiconductor layer 204. In this case, the semiconductor layer 204 may be constituted by a compound semiconductor such as, for example, cadmium zinc telluride.

The upper electrode 203 and the lower electrodes 205 are constituted by a conductor. The upper electrode 203 and the lower electrodes 205 may be constituted by a metal such as copper, for example.

The detection unit 202 is at least partially covered by an insulating layer 206. A specific arrangement of the insulating layer 206 will be described hereinafter. The insulating layer 206 partially covers the upper surface of the upper electrode 203. The part of the insulating layer 206 that partially covers the upper surface of the upper electrode 203 contacts the upper surface of the upper electrode 203. The part of the upper surface of the upper electrode 203 that is not covered by the insulating layer 206 is used to connect a conductive member 210.

The insulating layer 206 includes a part that covers the side surfaces of the upper electrode 203. The part of the insulating layer 206 that covers the side surfaces of the upper electrode 203 contacts the side surfaces of the upper electrode 203. In the example illustrated in FIG. 2, the insulating layer 206 covers all four side surfaces of the upper electrode 203. Instead, however, the insulating layer 206 may only cover some of the four side surfaces of the upper electrode 203.

The insulating layer 206 includes a part that covers the side surfaces of the semiconductor layer 204. The part of the insulating layer 206 that covers the side surfaces of the semiconductor layer 204 contacts the side surfaces of the semiconductor layer 204. In the example illustrated in FIG. 2, the insulating layer 206 covers all four side surfaces of the semiconductor layer 204. Instead, however, the insulating layer 206 may only cover some of the four side surfaces of the semiconductor layer 204.

The insulating layer 206 includes a part that covers a part of the lower surface of the semiconductor layer 204. The part of the insulating layer 206 that covers the part of the lower surface of the semiconductor layer 204 contacts the lower surface of the semiconductor layer 204.

When the upper surface of the board 201 is viewed in plan view, that upper surface includes a part that overlaps with the semiconductor layer 204, and a part that does not overlap with the semiconductor layer 204. The insulating layer 206 includes a part that covers the part of the upper surface of the board 201 that does not overlap with the semiconductor layer 204.

The insulating layer 206 includes a part that covers the side surfaces of the board 201. The part of the insulating layer 206 that covers the side surfaces of the board 201 contacts the side surfaces of the semiconductor layer 204. In the example illustrated in FIG. 2, the insulating layer 206 covers all four side surfaces of the board 201. Instead, however, the insulating layer 206 may only cover some of the four side surfaces of the board 201.

The insulating layer 206 includes a part that covers the lower surface of the board 201. The part of the insulating layer 206 that covers the lower surface of the board 201 contacts the lower surface of the semiconductor layer 204. In the example illustrated in FIG. 2, the insulating layer 206 contacts the entire lower surface of the board 201. As described above, the insulating layer 206 extends from the top of the board 101 to the sides of the board 101, and further extends to the bottom of the board 101.

The insulating layer 206 may be constituted by an inorganic material, for example. Specifically, the insulating layer 206 may be constituted by an oxide, a nitride, or an oxynitride. More specifically, the insulating layer 206 may be constituted by silicon nitride, silicon oxide, silicon oxynitride, or aluminum oxide. The insulating layer 206 may be constituted by a single layer, or may be constituted by a layered body including a plurality of layers. When the insulating layer 206 is constituted by layers, each of the plurality of layers may be constituted by the same material, or may be constituted by different materials. The insulating layer 206 may be constituted by an organic material, for example. Furthermore, the insulating layer 206 may be a layered body including an inorganic material and an organic material.

Covering part of the detection unit 202 with the insulating layer 206 makes it possible to separate that part of the detection unit 202 from the exterior (e.g., from air inside a housing of the radiation detection apparatus 200). This makes it possible to suppress degradation of the detection unit 202 caused by external influences. Because the insulating layer 206 protects the detection unit 202 from the exterior in this manner, the insulating layer 206 may be called a protective layer or an insulating protective layer.

The upper surface of the board 201 is covered by an insulating layer 211. The insulating layer 211 contacts the upper surface of the board 201. The insulating layer 211 also contacts the side surfaces of the lower electrodes 205. The insulating layer 211 contacts the entirety of the part of the lower surface of the semiconductor layer 204 not contacting the lower electrodes 205. An insulating layer that functions as a protective layer can be considered to be constituted by the insulating layer 206 and the insulating layer 211.

The lower electrodes 205 (specifically, the lower surfaces thereof) are electrically connected to an interconnect layer 208 formed within the board 101 through plugs 212. The interconnect layer 208 is electrically connected to other circuits formed on the board 201, or to other circuits formed on a board different from the board 201. When the radiation detection apparatus 200 is in use, a signal corresponding to the charge generated in the semiconductor layer 204 is transmitted to other circuits through this interconnect layer 208.

One end of the conductive member 210 is connected to an electrode 209 formed on the board 201. The other end of the conductive member 210 is connected to the upper electrode 203 (specifically, to the upper surface thereof). The electrode 209 and the upper electrode 203 are electrically connected to each other by the conductive member 210. The electrode 209 is electrically connected to other circuits formed on the board 201, or to other circuits formed on a board different from the board 201, through interconnects formed on the board 201. When the radiation detection apparatus 200 is in use, a predetermined potential is supplied to the upper electrode 203 from other circuits.

The sealing member 207 seals the conductive member 210. Furthermore, the sealing member 207 may cover the upper surface and side surfaces of the semiconductor layer 204. The sealing member 207 is constituted by an insulating member, and may be an organic material or an inorganic material. Alternatively, the sealing member 207 may be constituted by the same material as the insulating layer 206 described above.

The board 201 may include a connection part for connecting to an external circuit. This connection part is disposed so as to be distanced from the semiconductor layer 204 in plan view. A pad electrode may be used for the connection to the external circuit.

The radiation detection apparatus 200 may have a thermal insulation region in a region between the connection part and the semiconductor layer 204 in plan view. Providing the thermal insulation region makes it difficult for heat produced when connecting the pad electrodes to be transferred to the semiconductor layer 204. The thermal insulation region may include a thermal insulation part having a lower thermal conductivity than the board 201, for example. The thermal insulation part may be realized by making the board 201 thinner than other members, i.e., by making a part of the board 201 into a cavity, or by providing a member different from the board 201 and having a lower thermal conductivity than the board 201. When the thermal insulation region is formed by making the board 201 thinner, the thickness of the board in the thermal insulation region is lower than the thickness of the board in the region overlapping with the semiconductor layer 204 in plan view.

In the example in FIG. 2, the insulating layer 206 covers the top and sides of the detection unit 202, respectively. Instead, however, the insulating layer 206 may only cover some of the top and the sides of the detection unit 202, e.g., only the top or only the sides. In this case, the part covered by the insulating layer 206 is protected from the exterior.

A method for manufacturing the radiation detection apparatus 200 will be described. The lower electrodes 205 and the insulating layer 211 are formed on the board 201 on which the interconnect layer 208, the plugs 212, and the like are formed. Then, the semiconductor layer 204 is formed on the lower electrodes 205 and the insulating layer 211. As described above, the semiconductor layer 204 produces a charge corresponding to incident radiation. Then, the upper electrode 203 is formed on the semiconductor layer 204. As described above, the upper electrode 203 has a lower surface contacting the semiconductor layer 204 and an upper surface opposite the lower surface. Then, the insulating layer 206 that contacts the upper surface of the upper electrode 203 is formed. The insulating layer 206 may be formed through a low-temperature film deposition technique, for example. If the insulating layer 206 is an inorganic material, the insulating layer 206 may be formed through chemical vapor deposition (CVD) or atomic layer deposition (ALD), for example. If the insulating layer 206 is an organic material, the insulating layer 206 may be formed through dipping, spin coating, or the like using a resin as a material. As described above, the insulating layer 206 may cover the side surfaces of the semiconductor layer 204 and a part of the board 201. Then, a part of the insulating layer 206 is removed, and the conductive member 210 is formed on the parts from which the insulating layer 206 was removed. The detection unit 202 is then sealed with the sealing member 207.

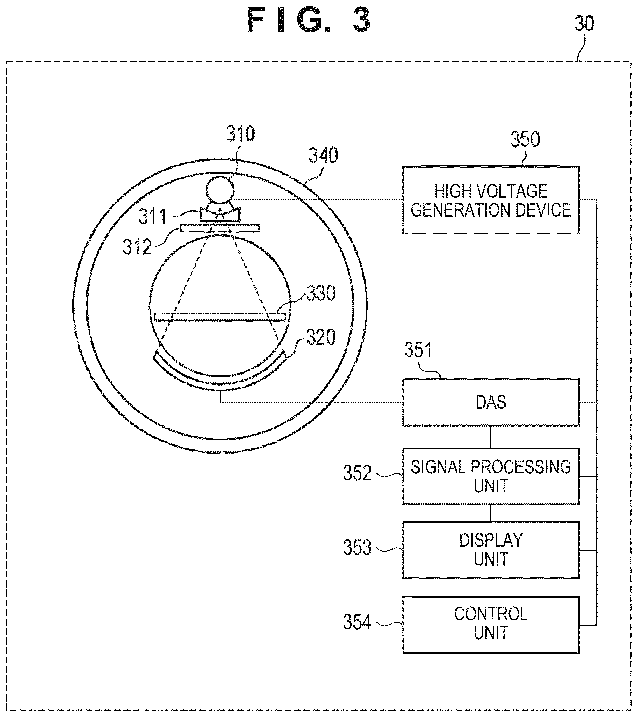

FIG. 3 is a block diagram illustrating a radiation CT apparatus according to the present embodiment. The above-described radiation detection apparatuses 100 and 200 can be applied in a detector of the radiation CT apparatus. The following will describe a case where the radiation detection apparatus 100 is used, but the radiation detection apparatus 200 may be used instead. A radiation CT apparatus 30 according to the present embodiment includes a radiation generation unit 310, a wedge 311, a collimator 312, a radiation detection unit 320, a top plate 330, a rotating frame 340, a high voltage generation device 350, a Data Acquisition System (DAS) 351, a signal processing unit 352, a display unit 353, and a control unit 354.

The radiation generation unit 310 is constituted by, for example, a vacuum tube that generates X-rays. A high voltage and filament current are supplied to the vacuum tube of the radiation generation unit 310 from the high voltage generation device 350. X-rays are produced when thermoelectrons are emitted from a cathode (filament) toward an anode (target).

The wedge 311 is a filter that adjusts the radiation dose emitted from the radiation generation unit 310. The wedge 311 attenuates the radiation dose such that the radiation emitted from the radiation generation unit 310 to a subject has a predetermined distribution. The collimator 312 is constituted by a lead plate or the like that narrows the irradiation range of radiation transmitted through wedge 311. The radiation generated by the radiation generation unit 310 is formed into a cone beam shape through the collimator 312 and emitted onto the subject on the top plate 330.

The radiation detection unit 320 is configured using the radiation detection apparatus 100 described above. The radiation detection unit 320 detects the radiation passing through the subject from the radiation generation unit 310, and outputs a signal corresponding to the radiation dose to the DAS 351.

The rotating frame 340 is annular and configured to be capable of rotating. The radiation generation unit 310 (the wedge 311 and the collimator 312) and the radiation detection unit 320 are disposed facing each other within the rotating frame 340. The radiation generation unit 310 and the radiation detection unit 320 are capable of rotating with the rotating frame 340.

The high voltage generation device 350 includes a booster circuit, and outputs a high voltage to the radiation generation unit 310. The DAS 351 includes an amplification circuit and an A/D conversion circuit, and outputs signals from the radiation detection unit 320 as digital data to the signal processing unit 352.

The signal processing unit 352 includes a CPU (Central Processing Unit), a ROM (Read Only Memory), a RAM (Random Access Memory), and the like, and can execute image processing for digital data. The display unit 353 includes a flat-panel display device or the like, and is capable of displaying radiographs. The control unit 354 includes a CPU, a ROM, a RAM, and the like, and controls the operations of the radiation CT apparatus 30 as a whole.

The foregoing described an embodiment in which the radiation detection apparatus 100 is used in the radiation CT apparatus 30. Instead, however, the radiation detection apparatus 100 or the radiation detection apparatus 200 may be used as an area sensor.

The present invention is not limited to the above embodiments and various changes and modifications can be made within the spirit and scope of the present invention. Therefore, to apprise the public of the scope of the present invention, the following claims are made.

This application claims priority from Japanese Patent Application No. 2023-034932, filed March 7, 2023, and the entire content thereof is hereby incorporated by reference herein.

## Claims

1. A radiation detection apparatus comprising:
a board;
a first electrode located on the board;
a semiconductor layer located on the first electrode, the semiconductor layer producing a charge corresponding to radiation incident on the radiation detection apparatus;
a second electrode located on the semiconductor layer, the second electrode having a first surface contacting the semiconductor layer and a second surface opposite the first surface; and
an insulating layer contacting the second surface of the second electrode.

2. The radiation detection apparatus according to claim 1,
wherein the semiconductor layer produces a charge corresponding to radiation incident on the semiconductor layer.

3. The radiation detection apparatus according to claim 1 or 2,
wherein the insulating layer includes an inorganic material.

4. The radiation detection apparatus according to claim 3,
wherein the insulating layer includes an oxide, a nitride, or an oxynitride.

5. The radiation detection apparatus according to claim 4,
wherein the insulating layer includes silicon nitride, silicon oxide, silicon oxynitride, or aluminum oxide.

6. The radiation detection apparatus according to claim 1 or 2,
wherein the insulating layer includes an organic material.

7. The radiation detection apparatus according to any one of claims 1 to 6,
wherein the second electrode further has a third surface connecting the first surface and the second surface, and
the insulating layer further contacts the third surface of the second electrode.

8. The radiation detection apparatus according to any one of claims 1 to 7,
wherein the board has a fourth surface on which the semiconductor layer is disposed, a fifth surface opposite the fourth surface, and a sixth surface connecting the fourth surface and the fifth surface,
the fourth surface of the board includes a part that does not overlap with the semiconductor layer, and
the insulating layer covers a part of the fourth surface of the board that does not overlap with the semiconductor layer.

9. The radiation detection apparatus according to claim 8,
wherein the insulating layer further covers the sixth surface of the board.

10. The radiation detection apparatus according to claim 9,
wherein the insulating layer further covers the fifth surface of the board.

11. The radiation detection apparatus according to any one of claims 1 to 7,
wherein the first electrode is bonded to the board by a bump.

12. The radiation detection apparatus according to claim 11,
wherein the semiconductor layer has a seventh surface contacting the first electrode,
the seventh surface includes a part not contacting the first electrode, and
the insulating layer contacts a part of the seventh surface of the semiconductor layer not contacting the first electrode.

13. The radiation detection apparatus according to any one of claims 1 to 10,
wherein the board has a connection part for connecting to an external circuit, and the connection part is separated from the semiconductor layer in plan view, and
a thermal insulation region is provided in a region between the connection part and the semiconductor layer in plan view.

14. The radiation detection apparatus according to claim 13,
wherein the thermal insulation region includes a thermal insulation part having a lower thermal conductivity than the board.

15. The radiation detection apparatus according to claim 14,
wherein the thermal insulation part is a cavity.

16. The radiation detection apparatus according to any one of claims 13 to 15,
wherein a thickness of the board in the thermal insulation region is lower than a thickness of the board in a region overlapping with the semiconductor layer in plan view.

17. A radiation CT apparatus comprising:
the radiation detection apparatus according to any one of claims 1 to 16;
a radiation generation unit that irradiates the radiation detection apparatus with radiation; and
a signal processing unit that processes a signal output from the radiation detection apparatus.

18. A manufacturing method for a radiation detection apparatus, the manufacturing method comprising:
forming a first electrode on a board;
forming, on the first electrode, a semiconductor layer that produces a charge corresponding to incident radiation;
forming, on the semiconductor layer, a second electrode having a first surface contacting the semiconductor layer and a second surface opposite the first surface; and
forming an insulating layer contacting the second surface of the second electrode.

19. The manufacturing method according to claim 18,
wherein the insulating layer is formed through a low-temperature film deposition technique.

20. The manufacturing method according to claim 18 or 19,
wherein the insulating layer is formed through chemical vapor deposition or atomic layer deposition.
